# EUROPÄISCHE PATENTANMELDUNG

(11) **EP 3 441 919 A1**
(43) Veröffentlichungstag der Anmeldung: **13.02.2019**
(21) Anmeldenummer: 17186018.2
(22) Anmeldetag: 11.08.2017
(51) Int. Cl.: G06Q 10/06, G06F 17/50

(54) **VERFAHREN ZUM AUSTAUSCH VON DATEN ZWISCHEN ENGINEERING-TOOLS EINES ENGINEERING-SYSTEMS SOWIE ENGINEERING-SYSTEM ZUR DURCHFÜHRUNG DES VERFAHRENS**

(71) Anmelder: Schneider Electric Industries SAS, 92500 Rueil-Malmaison (FR)
(72) Erfinder: JAHN, Herwig, 63533 Mainhausen (DE); DEVARAJA, Deepak, Bengaluru 560043 (IN)
(74) Vertreter: Stoffregen, Hans-Herbert

(57) **Zusammenfassung**

Die Erfindung betrifft ein Verfahren zum Austausch von Engineering-Daten (RED) zwischen unabhängigen Engineering-Tools (ET1...ETx) eines Engineering-Systems (ESY) sowie ein Engineering-System, wobei einem Projekt wie Fertigungsanlage, Schaltanlage oder Roboterzelle zugeordnete Engineering-Daten (ET1PD...ETxPD) jedes der Engineering-Tools (ET1...ETx) in einem dem Engineering-Tool zugeordneten Datenspeicher (SR, SPMR) in einem Tool-spezifischen Datenformat gespeichert werden und wobei von einem Benutzer selektierte, einer Systemfunktion (SF1...SFn) wie Projekt-Management-Funktion, Topologie-Management-Funktion, Variablen-Austausch-Funktion oder Diagnose-Funktion zugeordnete Engineering-Daten (ET1D...ETxD) der Engineering-Tools, die für zumindest ein weiteres der Engineering-Tools von Interesse sind, mittels einer Konvertierungseinheit (ETC1...ETCx) in ein standardisiertes Datenformat konvertiert und in einem standardisierten gemeinsamen Datenspeicher (CC) gespeichert werden. Um den Austausch von Engineering-Daten zur Engineering-Zeit zu optimieren und um eine minimale Redundanz ohne Änderung der existierenden Datenmodelle der Engineering-Tools zu erreichen, ist vorgesehen, dass Änderungen der selektierten, einer Systemfunktion (SF1...SFn) zugeordneten Engineering-Daten (ET1D...ETxD) der einzelnen Engineering-Tools (ET1D...ETxD) in dem standardisierten gemeinsamen Datenspeicher (CC) kontinuierlich zwischengespeichert und bei Bedarf jeder Zeit von einem der Engineering-Tools (ET1...ETx) gelesen werden und dass für einen temporären Zugriff auf die gesamten, dem Projekt zugeordneten Engineering-Daten (ET1PD...ET1XPD) durch ein anfragendes Engineering-Tool ein Start des bereitstellenden Engineering-Tools ausgeführt wird.

## Beschreibung

Die Erfindung bezieht sich auf ein Verfahren zum Austausch von Engineering-Daten zwischen unabhängigen Engineering-Tools eines Engineering-Systems, wobei einem Projekt wie Fertigungsanlage, Schaltanlage oder Roboterzelle zugeordnete Engineering-Daten jedes der Engineering-Tools in einem dem Engineering-Tool zugeordneten Datenspeicher in einem Tool-spezifischen Datenformat gespeichert werden und wobei von einem Benutzer selektierte, einer Systemfunktion wie Projekt-Management-Funktion, Topologie-Management-Funktion, Variablen-Austausch-Funktion oder Diagnose-Funktion zugeordnete Engineering-Daten der Engineering-Tools, die für zumindest ein weiteres der Engineering-Tools von Interesse sind, mittels einer Konvertierungseinheit in ein standardisiertes Datenformat konvertiert und in einem standardisierten gemeinsamen Datenspeicher gespeichert werden.

Ferner bezieht sich die Erfindung auf ein Engineering-System zum Austausch von Engineering-Daten zwischen unabhängigen Engineering-Tools des Engineering-Systems, wobei einem Projekt wie Fertigungsanlage, Schaltanlage oder Roboterzelle zugeordnete Engineering-Daten jedes der Engineering-Tools in einem dem Engineering-Tool zugeordneten Datenspeicher in einem Tool-spezifischen Datenformat gespeichert sind und wobei von einem Benutzer selektierte, einer Systemfunktion wie Projekt-Management-Funktion, Topologie-Management-Funktion, Variablen-Austausch-Funktion oder Diagnose-Funktion zugeordnete Engineering-Daten der Engineering-Tools, die für zumindest ein weiteres der Engineering-Tools von Interesse sind, mittels einer Konvertierungseinheit in ein standardisiertes Datenformat konvertiert und in einem standardisierten gemeinsamen Datenspeicher gespeichert werden.

Ein Verfahren sowie ein Engineering-System zur Durchführung des Verfahrens der eingangs genannten Art ist aus der WO 2012/066846 A1 bekannt. Bei dem bekannten Verfahren werden sämtliche Engineering-Daten eines ersten Engineering-Tools, die für ein zweites Engineering-Tool von Interesse sind identifiziert, konfiguriert und in einem elektronischen Datencontainer gespeichert. Der elektronische Datencontainer kann vorzugsweise eine Datei oder eine Datenbank sein. Jedes in dem elektronischen Datencontainer gespeicherte Datenelement ist mit einem Link zu den Originaldaten versehen sowie mit einer "Snapshot-Kopie" dieser Daten. Der elektronische Datencontainer mit diesen Daten wird durch das Ziel-Engineering-Tool oder eine separate Applikation geöffnet und visualisiert, wodurch eine Nur-Lese-Anzeige der importierten Daten in dem Ziel-Engineering-Tool bereitgestellt wird und wodurch der Import der Engineering-Daten ermöglicht wird.

Bei dem bekannten Verfahren werden Dateien mit ausgewählten Engineering-Daten zwischen zwei Engineering-Tools ausgetauscht. Diese Art des Datenaustauschs ist allerdings aufgrund des Erfordernisses der permanenten Dateisicherung, des Updates der Dateien sowie Leseoperationen nicht besonders leistungsfähig. Ferner ist es schwierig, die Engineering-Daten konsistent zu halten.

Des Weiteren sind aus dem Stand der Technik Verfahren bekannt, wobei Engineering-Tools über Interfaces direkt miteinander verbunden werden. Diese Verfahren weisen jedoch eine hohe Komplexität auf, um die einzelnen Verbindungen zwischen den Engineering-Tools zu steuern und die Konsistenz der Engineering-Daten zu bewältigen. Unabhängig davon muss das die Daten zur Verfügung stellende Engineering-Tool immer in Betrieb sein.

Ein konsequenter klassischer Ansatz mit zentraler Datenbank scheidet normalerweise aus, da die Umstellung aller Tooldaten auf die gemeinsame Datenbasis nicht akzeptable Modifikationsaufwände in den Tools bedeuten würden. Alternativ würde die gleichzeitige Beibehaltung von Engineering-Tool-Projekten und Datenbanken Schwierigkeiten mit der Konsistenz der Engineering-Daten verursachen. Außerdem ist in vielen Fällen eine ereignisbezogene direkte Datenverbindung von einem ersten Engineering-Tool zu einem zweiten Engineering-Tool effizienter als alle Engineering-Daten in einer Datenbank zu speichern. Ereignisbezogene direkte Datenübertragung bedeutet, dass nur dann Daten übertragen werden, wenn die Daten tatsächlich in dem zweiten Engineering-Tool benötigt werden und nicht generell bei jeder Aktualisierung innerhalb des ersten Engineering-Tools.

Üblicherweise werden Engineering-Daten in einem nicht standardisierten Format gespeichert, wodurch eine Konvertierung der Engineering-Daten bei einer Übertragung von einem Engineering-Tool zu einem anderen Engineering-Tool erforderlich ist.

Nach dem Stand der Technik kann auf die Engineering-Daten nur dann zugegriffen werden, wenn das entsprechende Engineering-Tool in Betrieb ist.

Informationen müssen nach dem Stand der Technik manuell in mehrere Tool-Projekte dupliziert werden, z. B. Variablen-Definitionen, IP-Adressen, Gerätebeschreibungen oder grafische Symbole, wodurch das Risiko besteht, dass die Daten nicht mehr konsistent sind. Folglich besteht der Wunsch nach standardisierten Datenformaten, die alle Engineering-Tools unterstützen. Dies resultiert jedoch in einer zusätzlichen Speicherung der duplizierten Daten. Datenduplikation kann zwar nicht ganz vermieden, sollte jedoch minimiert werden.

Davon ausgehend liegt der vorliegenden Erfindung die Aufgabe zugrunde, ein Verfahren und ein Engineering-System zur Durchführung des Verfahrens der eingangs genannten Art derart weiterzubilden, dass der Austausch von Engineering-Daten zur Engineering-Zeit optimiert und eine minimale Redundanz ohne Änderung der existierenden Datenmodelle der Engineering-Tools erreicht wird.

Die Aufgabe wird erfindungsgemäß dadurch gelöst, dass Änderungen der selektierten, einer Systemfunktion zugeordneten Engineering-Daten der einzelnen Engineering-Tools in dem standardisierten gemeinsamen Datenspeicher kontinuierlich zwischengespeichert und bei Bedarf jeder Zeit von einem der Engineering-Tools gelesen werden und dass für einen temporären Zugriff auf die gesamten, dem Projekt zugeordneten Engineering-Daten durch ein anfragendes Engineering-Tool ein Start des bereitstellenden Engineering-Tools ausgeführt wird.

Gemäß einer bevorzugten Verfahrensweise ist vorgesehen, dass die Zwischenspeicherung nach einer Zwischenspeicherungs-Strategie durchgeführt wird, wobei die Engineering-Daten entsprechend einer Datenklassifizierung zwischengespeichert werden, umfassend:
Cass-1-Daten, die zwischengespeichert und aktualisiert werden, so dass auf diese jederzeit zugegriffen werden kann, ohne dass das zugehörige Engineering-Tool in Betrieb ist,
Class-2-Daten, die teilweise zwischengespeichert werden, wobei das zugehörige Engineering-Tool vollen Zugriff auf die gesamten, einem Projekt zugeordneten Daten sicherstellt,
Class-3-Daten, die nicht zwischengespeichert werden, jedoch über das bereitstellende Engineering-Tool verfügbar sind und

Class-0-Daten, die nicht in das gemeinsame Datenmodell transformiert werden und ausschließlich über ein spezifisches Interface (SPMI) der Engineering-Tools (ET1...ETx) gelesen werden.

Ein Hauptmerkmal der vorliegenden Erfindung ist die Kollaboration von Engineering-Tools in Kombination mit einer Zwischenspeicherungs-Strategie auszutauschender Engineering-Daten und einer Start-Strategie für die Engineering-Tools .

Das erfindungsgemäße Verfahren zeichnet sich gegenüber dem Stand der Technik dadurch aus, dass ein effizienter Austausch von Daten zwischen einer Vielzahl von Engineering-Tools möglich wird, ohne dass die Engineering-Tools und / oder die Datenformate der Engineering-Tools geändert werden müssen.

Da nur ein Bruchteil der gesamten von einem Engineering-Tool verwalteten Daten für den Austausch relevant ist, genügt es, nur diesen Teil zu standardisieren und von jedem Tool zugreifbar zu machen. Somit bleibt der Aufwand für die zu realisierenden Schnittstellen, Konvertierungsroutinen sowie die Datenduplikation begrenzt.

Gemäß der Erfindung kann ein Teil der Engineering-Daten angeboten oder angefragt werden, selbst dann, wenn das anfordernde Engineering-Tool oder bereitstellende Engineering-Tool nicht in Betrieb ist. Für die einzelnen Engineering-Tools besteht kein Unterschied, ob diese auf zwischengespeicherte Engineering-Daten oder nichtzwischengespeicherte Engineering-Daten zugreifen.

Vorzugsweise werden die Systemfunktionen des Engineering-Systems in Form von Variablen-Management, Diagnose-Management, Firmware-Management, Applikations-Management, Funktions-Management, Netzwerk-Management, Hardwarekonfigurations-Management u.a. als standardisierte gemeinsame Domain-Services bereitgestellt, wobei die Engineering- Tools über die Domain-Services auf die gemeinsamen standardisierten Engineering-Daten zugreifen können.

Die Domain-Services stellen jeweils ein gemeinsames standardisiertes Datenmodell zur Darstellung ihrer Domain-Daten bereit.

Die Zwischenspeicherung von selektierten Engineering-Daten und/oder der Start eines der Engineering-Tools wird vorzugsweise unter Berücksichtigung von Datenselektionskriterien, Selektionsstatistiken statischen Informationen und/oder dynamischen Informationen ausgeführt. Die Datenselektionskriterien werden vorzugsweise durch einen Benutzer vorgegeben und die Selektionsstatistiken werden vorzugsweise durch mitlesen der angeforderten Engineering-Daten erstellt.

Es ist vorgesehen, dass die Engineering-Tools über die Domain-Services untereinander sowie mit dem gemeinsamen standardisierten Datenspeicher kommunizieren.

Nach dem Abtrennen eines Engineering-Tools werden die auf ein Projekt bezogenen Engineering-Daten und/oder die auf eine Systemfunktion bezogenen Daten in dem gemeinsamen Datenspeicher gespeichert.

Die Konvertierung der Engineering-Daten in jedem einzelnen Engineering-Tool wird vorzugsweise mittels des Tool-Konnektors ausgeführt.

Das erfindungsgemäße Engineering-Tool zeichnet sich dadurch aus, dass die Systemfunktionen als Domain-Services mit einem gemeinsamen standardisierten Datenmodell ausgebildet sind, wobei Änderungen der selektierten, einer Systemfunktion zugeordneten Engineering-Daten der einzelnen Engineering-Tools mittels der Domain-Services in dem standardisierten gemeinsamen Datenspeicher kontinuierlich zwischengespeichert und bei Bedarf jeder Zeit von einem der Engineering-Tools lesbar sind und dass für einen temporären Zugriff auf die gesamten, dem Projekt zugeordneten Engineering-Daten durch ein anfragendes Engineering-Tool mittels eines Start-Mechanismus ein Start des bereitstellenden Engineering-Tools und/oder des die Daten bereitstellenden Daten-Servers ausgeführt wird.

Um zu vermeiden, dass Benutzer durch den Start eines Engineering-Tools bei Ihrer Arbeit gestört werden, ist vorgesehen, dass Instanzen der Engineering-Tools auf dem Engineering-Server installiert sind und dass die Instanz des Engineering-Tools auf den Engineering-Server gestartet wird, um auf die gesamten Daten dieses Engineering-Tools zuzugreifen.

Das erfindungsgemäße Engineering-System, umfassend die Engineering-Tools sowie ein System-Tool, ermöglicht eine Gesamtsicht auf eine Automatisierungsarchitektur einer Fertigungsanlage, Fertigungslinie oder Maschine. Das System stellt eine kollaborative Umgebung für sämtliche Lebenszyklen eines Automatisierungstools einschließlich Automatisierungstools von Drittanbietern zur Verfügung. Zudem besteht die Möglichkeit, die Softwarekonfiguration des Systems entsprechend den Anforderungen eines Benutzers zu skalieren.

Das erfindungsgemäße Engineering-System bildet ein Framework zur Kollaboration von Engineering-Tools in Kombination mit den als Domain-Services ausgebildeten Systemfunktionen auf Systemlevel. Insbesondere wird die gemeinsame Benutzung von Daten zwischen den Engineering-Tools und den als Domain-Services ausgebildeten Systemfunktionen ermöglicht.

Gegenüber Engineering-Systemen aus dem Stand der Technik, zeichnet sich das erfindungsgemäße System dadurch aus, dass die Beteiligung von Engineering-Tools an dem Engineering-System skalierbar ist. Die Engineering-Tools können über die Vielzahl von Domain-Interfaces selbst entscheiden, an welchen Systemfunktionen bzw. Domain-Service wie beispielsweise Projekt-Management-Service, Topologie-Management-Service, Laufzeit-Daten-Austausch-Definitions-Service u.a. diese mitwirken möchten. Die Engineering-Tools entscheiden selbst, zu welchem Zeitpunkt diese mitwirken möchten.

Aufgrund der Verwendung eines standardisierten Datenmodells in Kombination mit einem Datenkonverter für jedes einzelne Engineering-Tool ist eine Änderung des individuellen Datenmodells der einzelnen Engineering-Tools nicht mehr zwingend notwendig.

Ein weiteres erfindungsgemäßes Merkmal ist die Kollaboration zwischen Engineering-Tools einerseits und den Domain-Services auf der Grundlage von in dem jeweiligen Domain-Speicher gespeicherten Daten.

Vorzugsweise sind die standardisierten Datenmodelle permanent verfügbar. Die Domain-Interfaces der einzelnen Domain-Services sind ausgebildet, um gezielt auf Daten von einem bestimmten Engineering-Tool zugreifen zu können. Das gemeinsame Datenmodell ist die Summe aller Daten, welche die Engineering-Tools permanent offenlegen möchten.

Um zeitweise auf die vollständigen Daten eines der Engineering-Tools zugreifen zu können, kann das Engineering-Tool über den entsprechenden Tool-Konnektor gestartet werden, wie dies später erläutert wird.

Das Engineering-System erlaubt die Unterstützung von Standards wie OPC-UA und AML, deren Schnittstellen dann auf den Domain-Services aufsetzen. Auch ist es durch semantische Unterstützungsmerkmale erweiterbar.

Des Weiteren ist anzumerken, dass nur diejenigen Engineering-Tools installiert werden müssen, die von dem Benutzer zur Erledigung seiner Aufgabe benötigt werden, wenngleich die Vorteile eines vollständigen Datenaustauschs solange erhalten bleiben, wie ein kollaboratives Engineering-Tools in dem System installiert ist. Daraus ergeben sich Vorteile wie Skalierbarkeit, Konfektionierbarkeit und reduzierte Komplexität. Insbesondere ist ein dedizierter kostspieliger Server mit großem Arbeits- und Festplattenspeicher sowie hoher Leistungsfähigkeit nicht zwingend notwendig, so dass schon im Einsatz befindliche leistungsschwächere Laptops weiterverwendet werden können.

Als wesentliches erfindungsgemäßes Merkmal ist hervorzuheben, dass das konsequent up-to-date gepufferte standardisierte Datenmodell zu jeder Zeit für die Engineering-Tools über die Domain-Services zugreifbar ist.

Durch die erfindungsgemäße Implementierungsstrategie wird sichergestellt, dass das standardisierte Datenmodell jederzeit verfügbar ist. Es erfolgt ein Ausgleich zwischen der Persistenz von redundanten Daten und der Verfügbarkeit von Engineering-Tools.

Ferner sind Mechanismen zur Datenrückgewinnung vorgesehen, um nach dem Abtrennen eines der Engineering-Tools von dem gemeinsamen Datenspeicher auf alte Daten zugreifen zu können.

Durch die Domain-Interfaces werden die Datenkonverter zur Konvertierung eines spezifischen Datenmodells des Engineering-Tools in ein standardisiertes Datenmodell bereitgestellt.

Gegenüber dem Stand der Technik wird durch das erfindungsgemäße Engineering-System ein neuer Ansatz verfolgt, nämlich weg von komplexen integrierten Engineering-Tools und hin zu verteilten skalierbaren Funktionen.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung eines den Zeichnungen zu entnehmenden bevorzugten Ausführungsbeispiels.

Es zeigen:
- Fig. 1: eine schematische Darstellung eines Engineering-Systems,
- Fig. 2: eine schematische Darstellung eines Verfahrensschaubildes zur Beeinflussung der Zwischenspeicherung von Engineering-Daten und der Start-Strategie zum Start von Engineering-Tools,
- Fig. 3 3: eine schematische Darstellung einer Kommunikation zwischen einem Engineering-Tool und einem Domain-Service zur Anfrage von Engineering-Daten,
- Fig. 4: eine schematische Darstellung einer Kommunikation zwischen einem Engineering-Tool und einem Domain-Service zum Updaten von Engineering-Daten in einem Zwischenspeicher,
- Fig. 5: eine schematische Darstellung eines Verfahrensschaubildes zur Erläuterung des Zusammenwirkens der Engineering-Tools mit Systemfunktionen des Engineering-Systems über eine Kommunikationsplattform,
- Fig. 6: eine schematische Darstellung einer Kommunikation zwischen einem Engineering-Tool und einem Domain-Service zur Darstellung einer Zwischenspeicherungs-Strategie sowie einer Start-Strategie für die Engineering-Tools,
- Fig. 7: eine schematische Darstellung eines Austauschs von Engineering-Daten zwischen zwei auf einer Workstation (lokal) installierten Engineering-Tools,
- Fig. 8: eine schematische Darstellung eines Austauschs von Engineering-Daten zwischen zwei auf verschiedenen Workstations installierten Engineering-Tools,
- Fig. 9: eine schematische Darstellung eines Austauschs von Engineering-Daten zwischen zwei Engineering-Tools, von denen ein Engineering-Tool nicht in Betrieb ist und
- Fig. 10: eine schematische Darstellung eines Austauschs von Engineering-Daten zwischen zwei Engineering-Tools, die auf verschiedenen Workstations installiert sind und von denen ein Engineering-Tool gestartet wird.

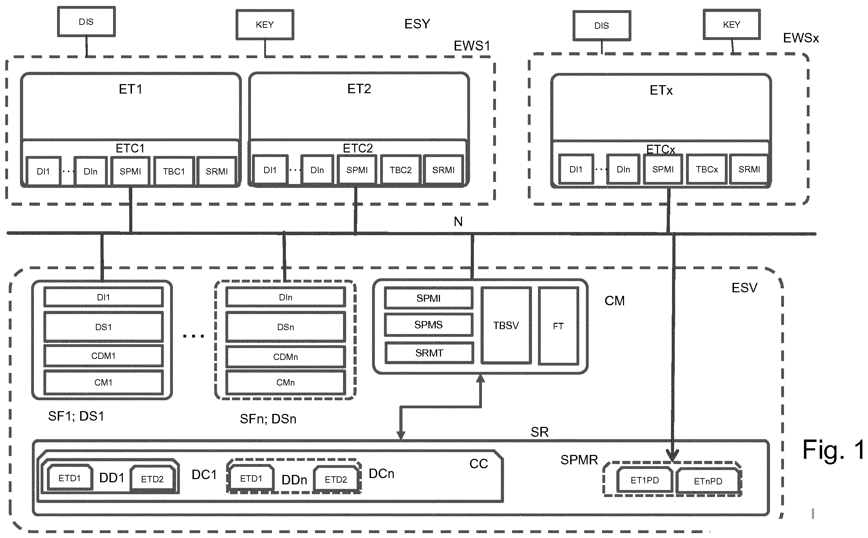

Fig. 1 zeigt rein schematisch ein erfindungsgemäßes Engineering-System ESY, umfassend eine Vielzahl von Engineering-Tools ET1... ETx, die über ein Kommunikationsnetzwerk N wie Bussystem mit einem Engineering-Server ESV gekoppelt sind, um ein arbeitsteiliges Engineering zu ermöglichen. In dem dargestellten Ausführungsbeispiel sind die Engineering-Tools ET1, ET2 in einer Engineering-Workstation EWS1 und das Engineering-Tool ETx in einer Engineering-Workstation EWSx gehostet. Die Engineering-Workstations EWS1... EWSx können jeweils eine Anzeigeeinheit DIS sowie eine Eingabeeinheit KEY aufweisen.

Das Engineering-System ESY umfasst desweiteren eine Vielzahl von Systemfunktionen SF1... SFn, wie z. B. Projekt-Management-Funktion, Topologie-Funktion, Variablen-Austausch-Funktion, Diagnose-Funktion u.a., die in dem dargestellten Ausführungsbeispiel auf dem Engineering-Server ESV installiert sind. Alternativ können die Systemfunktionen SF1... SFn in Form von einem oder mehreren Systemtoolsauf einer oder mehreren Engineering-Workstations EWS1... EWSx oder in einer Cloud installiert sein.

Die Systemfunktionen SF1... SFn sind jeweils als eine Domain klassifiziert und als standardisierter Domain-Service DS1... DSn realisiert, welcher über ein Domain-Interface DI1... DIn aufrufbar ist. Jeder Domain-Service DS1...DSn publiziert ein standardisiertes Datenmodel CDM1...CDMn, um seine Domaindaten zu repräsentieren. Die Domain-Services DS1 ... DSn sind mit dem Kommunikationsnetzwerk N gekoppelt und können über ein Kollaborations-Modul CM auf einen System-Datenspeicher SR zugreifen. Der System-Datenspeicher SR umfasst vorzugsweise einen Projekt-Datenspeicher SPMR für Projektdaten ETPD1... ETPDn der Engineering-Tools ET1... ETn, die in einem Tool-spezifischen Datenformat gespeichert sind. Ferner umfasst der System-Datenspeicher SR einen gemeinsamen, standardisierten Zwischenspeicher CC, der entsprechend den Domain-Services DS1...DSn in Speicher-Domains DC1 ... DCn zur Zwischenspeicherung von Domaindaten DD1...DDn aufgeteilt ist. In den Speicher-Domains DC1... DCn sind jeweils selektierte, einem Domain-Service DS1... DSn zugeordnete standardisierte und für die Domain selektierte Engineering-Daten ET1D...ETnDz. B. der teilnehmenden Engineering-Tools ET1, ET2 gespeichert. Die Domain-Services DS1... DSn verfügen jeweils über ein Cache-Management-Modul CM1...CMn, welches die Strategie der Zwischenspeicherung und Synchronisierung von Engineering-Daten in Abhängigkeit der Verfügbarkeit der Engineering-Tools ET1...ETn definiert.

In dem Kollaborations-Modul CM ist ein System-Projekt-Management-Interface SMPI mit entsprechendem Projekt-Management-Service SPMS, ein System-Datenspeicher-Management-Tool SRMT, ein zentraler Tool-Steuerungs-Server TBSV sowie eine Speicherzugriffs-Steuerung installiert. Das Kollaborations-Modul CM steuert die Engineering-Tools ET1...ETn, den Austausch von Engineering-Daten ETD1...ETDn zwischen den Engineering-Tools ET1...ETx, den Domain-Services DS1... DSn sowie den Speicher-DomainsDC1...DCn. Mittels des System-Projekt-Management-Service SPMS werden Systemfunktionsdaten und Engineering-Tool-Projektdaten der teilnehmenden Engineering-Tools verwaltet.

Das System-Datenspeicher-Management-Tool SRMT ermöglicht Zugriff auf den System-Datenspeicher SR für das System-Projekt-Management-Interface SPMI oder jeden anderen Domain-Service DS1...DSn. Der System-Datenspeicher SR ist die gemeinsame Datenspeicherungsinfrastruktur, die irgendwo im Netzwerk N lokalisiert sein kann. Im dargestellten Ausführungsbeispiel ist der Systemspeicher SR in dem Engineering-Server ESV installiert.

DieEngineering-Tools ET1... ETx sind jeweils über einen Tool-KonnektorETC1... ETCx mit dem Kommunikationsnetzwerk N gekoppelt. Der Tool-Konnektor ETC1... ETCx stellt Domain-Interfaces DI1 ... DIn für jeden Domain-Service DS1... DSn bereit, der unterstützt werden soll. Der Tool-KonnetorETC1...ETCn ist gemäß der Erfindung ausgebildet, um die Engineering-Daten ETD1... ETDx von einem Tool-spezifischen Datenformat des Engineering-Tools in ein standardisiertes Datenformat der Domain-Services zu konvertieren.

Ferner umfasst der Tool-Konnektor ETC1...ETCx jeweils ein System-Projekt-Management-Interface SPMI sowie ein System-Datenspeicher-Management-Interface SRMI für den unmittelbaren Zugriff auf den Projektdatenspeicher SPMR.

Dem erfindungsgemäßen Verfahren liegt ein Daten-Management zugrunde, bei dem die Daten in verschiedene Klassen aufgeteilt werden, die die Zwischenspeicherungsstrategie sowie die Startstrategie für die Engineering-Tools beeinflussen.

Als "Class 1 "-Daten werden solche bezeichnet, die durch einen Benutzer definiert, vollständig zwischengespeichert, up-to-date gehalten werden und die erreichbar sind, ohne dass das bereitstellende Engineering-Tool im Hintergrund laufen muss. Dies entspricht einer Duplikation von Daten in dem "Tool-Projekt". Die Datenkonvertierung zwischen den Datenformaten wird durch den Tool-Konnektor ETC1...ETCn durch Konvertierungsmittel durchgeführt. Die Duplikation betrifft jedoch nur häufig benutzte Daten mit einem Anteil von < 20 % der gesamten Datenmenge.

Als "Class 2"-Daten werden solche bezeichnet, die teilweise zwischengespeichert sind, wobei das im Hintergrund laufende bereitstellende Engineering-Tool vollen Zugriff auf alle Daten bereitstellt, falls dies gewünscht wird.

"Class 1 und 2"-Daten werden in dem gemeinsamenstandardisierten Zwischenspeicher CC, welcher durch das Engineering-System ESY bereitgestellt wird, zwischengespeichert.

Als "Class 3"-Daten werden solche bezeichnet, die nicht zwischengespeichert, jedoch über das im Hintergrund laufende bereitstellende Engineering-Tool verfügbar sind, nachfolgend als "virtuelle" Zwischenspeicherung bezeichnet. Die Daten sind zwar vorhanden, müssen jedoch von dem jeweiligen Tool-Konnektor geladen und konvertiert werden. Diese Datenkategorie wird für weniger häufig verwendete Daten verwendet.

Die "Class 2"- und "Class 3"-Daten können automatisch durch das Engineering-System basierend auf Selektions-Kriterien und/oder Selektions-Statistiken bestimmt werden, die später erläutert werden.

Sogenannte "Class 0"-Daten sind dem Engineering-System nicht bekannt und werden nicht in das standardisierte Datenmodell (Common-Data-Model) transformiert. Folglich kann auf diese Daten nur über die spezifischen Interfaces, SRMI zugegriffen werden. Auf die "Class 1, 2 und 3"-Daten kann über die identischen Interfaces DI1...DIn, basierend auf dem standardisierten Datenmodell (Common-Data-Model) und über die "virtuelle" Zwischenspeicherung zugegriffen werden.

Sollte ein Start eines bereitstellenden Engineering-Tools notwendig sei, kann dieser Start von überall in dem Netzwerk N erfolgen; z. B. ist es nicht notwendig, dass das bereitstellende Engineering-Tool ET1 auf der Workstation EWS1 installiert ist, von der ein Benutzer und/oder ein anfragendes Engineering-Tool die Daten anfragt. Typischerweise wird eine dedizierter Daten-Server gestartet, damit ein Benutzer einer Workstation nicht bei seiner Arbeit gestört wird, wenn im Hintergrund ein Engineering-Tool gestartet und eine Meldung auf einer Benutzeroberfläche angezeigt würde.

Gemäß der Erfindung werden die standardisierten Daten ETD1, ETD2 in Domains DD1, DDn organisiert, wodurch die Leistungsfähigkeit der Kollaboration der Engineering-Tools unterstützt wird.Die Domain-spezifische Organisation der Systemfunktionen SF1... SFn erlaubt eine Reduktion der Komplexität und unterstützt die Wiederverwendbarkeit.Auch wird die Wiederverwendbarkeit dieser Komponenten innerhalb jeder Systemarchitektur vereinfacht. Die Entwicklungszeit zur Ermöglichung der Mitwirkung der Engineering-Tools wird reduziert, da die Engineering-Tools typischerweise nur an einer Teilmenge der Domains DS1... DSn mitwirken. Die Engineering-Tools können Schritt für Schritt den Umfang ihrer Mitwirkung vergrößern, während die Kollaboration mit einer ersten Domain bereits besteht.

Aus Sicht eines Benutzers erscheinen die als Domain-Services DS1... DSn realisierten System-Funktionen SF1... SFn wie eine "App" auf einem mobilen Gerät, z. B. als ein kleines Teil eines Anwenderprogramms. Diese "Apps" können separat installiert und deinstalliert werden und stellen eine handhabbare Einheit von Merkmalen dar. Die Zwischenspeicherungs-Strategie für Daten und die Start-Strategie für die Engineering-Tools kann für jede Domain individuell bestimmt werden.

Um die Menge der in dem Engineering-System ESY auszutauschenden Daten zu reduzieren, ist gemäß der Erfindung vorgesehen, dass die Datenmenge durch Selektions-Kriterien reduziert wird. Dabei soll ein Maximum an Verfügbarkeit sichergestellt werden.

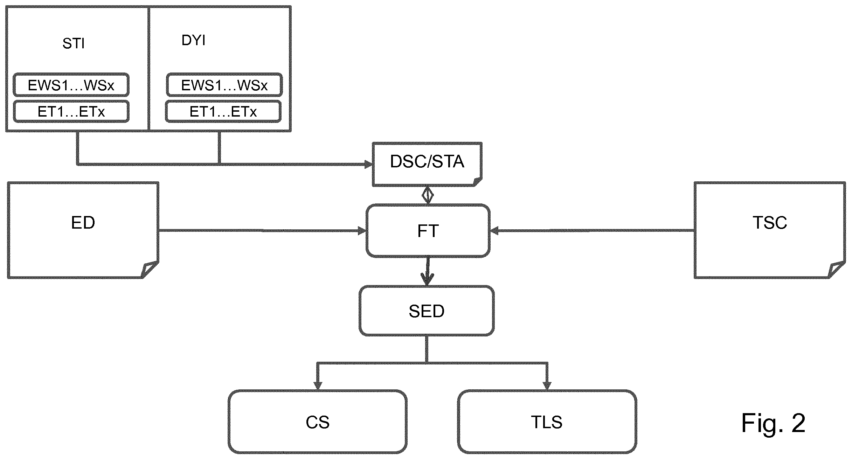

Gemäß der Erfindung weist das Engineering-System ESY ein Filter-Tool FT auf, dessen Funktion in Fig. 2 schematisch dargestellt ist. Das Filter-Tool FT ist ausgebildet, um die Kommunikation und den Datenaustausch zwischen den Engineering-Tools und den Domain-Services DS1...DSn mitzulesen. Das Filter-Tool FT wird mittels DatenselektionsKriterien DSC konfiguriert. Da das Engineering-System ESY über das Filter-Tool FT den Austausch von Engineering-Daten ED zwischen den Engineering-Tools ET1... ETx und den Domain-Services DS1... DSn mitliest, d. h. die auszutauschenden Daten dem System bekannt sind, kann auf der Grundlage der Datenselektionskriterien eine Datenselektion erfolgen. Die gefilterten bzw. selektierten Daten SED werden jeweils in denZwischenspeichernDC1...DCn zwischengespeichert.

Das Filter-Tool FT ist des Weiteren ausgebildet, um auf der Grundlage der mitgelesenen Daten bzw. Nachrichten Statistiken STA zu generieren. Dies bedeutet, dass der Inhalt von Anfragen zwischen Engineering-Tools ET1...ETx sowie Anfragen zwischen Domain-Services DS1... DSn und Engineering-Tools ET1...ETx sowie die Häufigkeit von Anfragen und ggf. weitere Kriterien überprüft werden. Z. B. werden Daten, die häufig angefragt werden, in denZwischenspeichernDC 1... DCn zwischengespeichert.

Die Datenselektion kann auf der Grundlage der Datenselektionskriterien DSC, der Grundlage der Statistiken STA sowie durch eine Kombination der Datenselektionskriterien DSC mit den Statistiken STA erfolgen.

Die Selektionskriterien DSC können über das gemeinsame Filter-Tool FT realisiert werden. Das Filter-Tool FT überprüft Anfragen und Angebote von Engineering-Daten ED. Daten, die oft angefragt werden, sollen gespeichert werden.

Die Datenselektionskriterien DSC können mittels statischer Informationen STI festgelegt werden, z. B einmal manuell zu Beginn des Engineering-Verfahrens. Beispielsweise kann es von vorneherein bekannt sein, dass das Engineering-Tool ETx bestimmte Daten publizieren muss, die die Engineering-Tools ETy und ETz in jedem Fall benötigen.

Eine weitere Möglichkeit besteht darin, zur Festlegung der Datenselektionskriterien DSC dynamische Informationen DYI zu verwenden, die zu jeder Zeit von einem Benutzer festgelegt werden können, wenn Daten von dem standardisierten Datenmodell (Common-Data-Model) angefragt werden.

Die Festlegung dynamischer Informationen DYI kann auch zur Erzeugung der Selektions-Statistiken STA herangezogen werden. Die Erzeugung dynamischer Informationen DYI erfordert nicht notwendigerweise eine zusätzliche Benutzeraktion; denn das anfragende Engineering-Tool kann ebenfalls von sich aus wissen, welche speziellen Kriterien die Daten erfüllen müssen und kann daher die Kriterien autonom festlegen

In diesem Zusammenhang ist anzumerken, dass Daten, welche ohnehin mit anderen Daten in dem Zwischenspeicher DC1...DCn verbunden sind, immer "ausgewählt" und automatisch in dem Zwischenspeicher gespeichert werden.

Die Anwendung der statischen Informationen STI sowie der dynamischen Informationen DYI der einzelnen Engineering-Tools ET1... ETx und deren Kombinationen mit gespeicherten Datenselektionskriterien DSC sowie der Konfiguration einer Engineering-Tool-Strategie TSC kann sowohl die Zwischenspeicherungs-Strategie CS für die selektierten Daten SED1...SEDx als auch die Start-Strategie TLS für die Engineering-Tools beeinflussen.

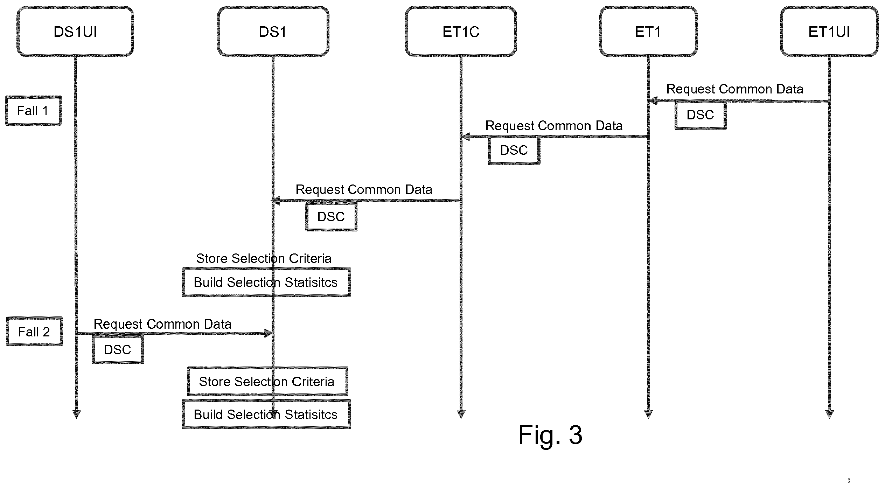

Fig. 3 zeigt rein schematisch ein Sequenzdiagramm zur Darstellung einer Kommunikation zwischen dem Engineering-Tool ET1 und dem Domain-Service DS1 des Engineering-Servers ESY. Über ein User-Interface ET1UI des Engineering-Tools ET1 gibt ein Benutzer eine Datenanfrage ein, die sich z. B. auf Variablen einer bestimmten Domainbeziehen. Die Anfrage "Request Common Data" wird unter Berücksichtigung von Datenselektionskriterien DSC über den Tool-Konnektor ET1C an den entsprechenden Domain-Service DS1 gesendet. Die Datenselektionskriterien DSC werden in dem Domain-Service DS1 gespeichert. Unabhängig davon wird die Anfrage "Request Common Data" durch das in dem Kommunikations-Modul KM implementierte Filter-Tool FT zur Bildung von Selektions-Statistiken "BuildSelectionStatistics" ausgewertet.

Alternativ besteht die Möglichkeit, dass eine Datenanfrage "Request Common Data" über ein User-Interface DS1UI des Domain-Service DS1 gesendet wird. Auch dies kann unter Berücksichtigung von Datenselektionskriterien DSC erfolgen. In dem Domain-Service DS1 werden die Datenselektionskriterien gespeichert "Store SelectionCriteria" und zur Erzeugung von Selektions-Statistiken "BuildSelectionStatistics" ausgewertet.

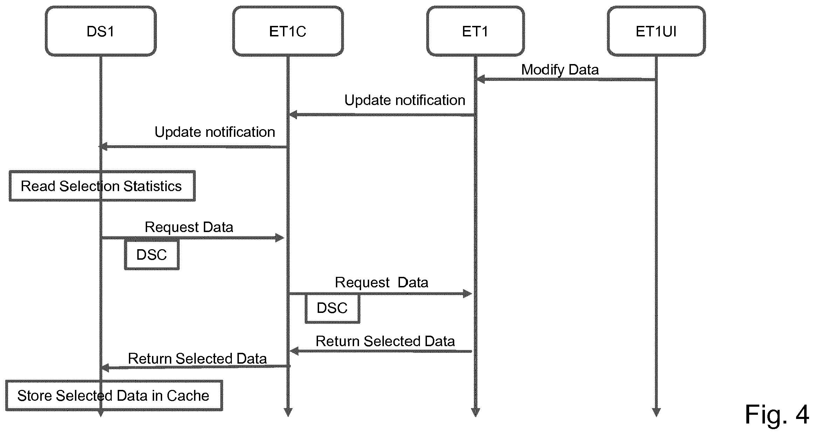

Fig. 4 zeigt ein Kommunikationsdiagramm zur Darstellung einer Kommunikation zwischen dem Engineering-Tool ET1 und beispielsweise dem Domain-Service DS1 betreffend das Update des Zwischenspeichers DC1 des Domain-Service DS1. Über das Benutzer-Interface ET1UI gibt ein Benutzer nach einer Modifizierung von Engineering-Daten den Befehl "Modify Data" ein. Das Engineering-Tool ET1 sendet über den Tool-Konnektor ET1C eine Update-Meldung "UpdateNotification" an den Domain-Service DS1. Der Domain-Service DS1 liest die der Anfrage entsprechenden Selektions-Statistiken "ReadSelectionStatistics" und sendet eine Anfrage "Request Data" unter Berücksichtigung von Selektionskriterien an das Engineering-Tool ET1.

Das Engineering-Tools ET1 sendet die selektierten Engineering-Daten SED über den Befehl "Return Selected Data" an den Domain-Service DS1, woraufhin die selektierten Daten in den dem Domain-Service DS1 zugeordneten Zwischenspeicher DC1 gespeichert werden.

Aus Obigem ergibt sich, dass ein Update des Zwischenspeichers DC1 auf der Grundlage von gespeicherten Selektions-Statistiken sowie benutzerdefinierten Datenselektionskriterien erfolgt.

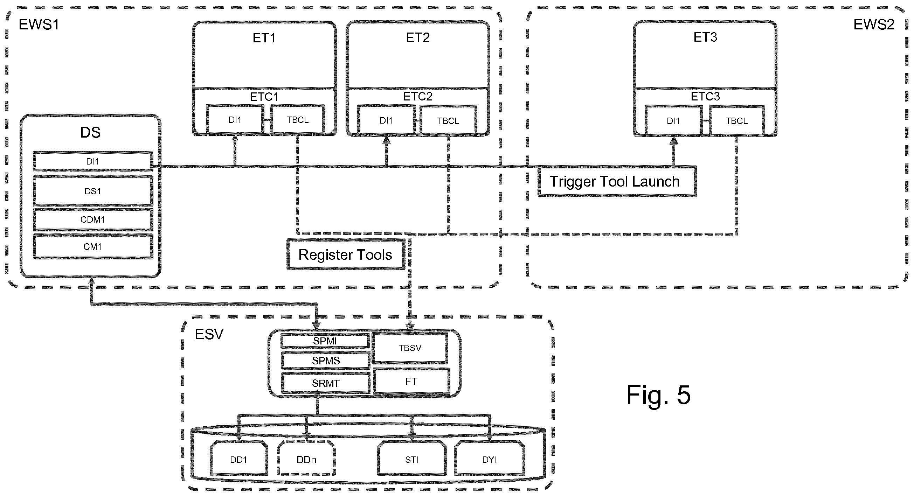

Fig. 5 zeigt rein schematisch das Engineering-System gemäß Fig. 1 in einer vereinfachten Darstellung. Der Domain-Service DS1ist zusammen mit den Engineering-Tools ET1, ET2 auf der Engineering-Workstation EWS 1 installiert.

Der Start der Engineering-Tools ET1...ET3 wird über einen Tool-Brocker-Service verwaltet, umfassend einen vorzugsweise zentralen Tool-Broker-Server TBSV, der mit entsprechenden Tool-Broker-Clients TBCL1, TBCL2, TBCL3 kommuniziert, die in den einzelnen Engineering-Tools ET1, ET2, ET3 implementiert sind.

Die Engineering-Tools ET1, ET2, ET3 registrieren sich über die Tool-Broker-Clients TBCL bei dem zentralen Tool-Broker-Server TBSV, welcher die statischen Informationen STI sowie dynamischen Informationen DYI der Engineering-Tools ET1, ET2 sowie ET3, die in dem Systemspeicher SR gespeichert sind, verwaltet. Ferner stellt der Tool-Broker-Server TBSV die Informationen zur Verfügung, um ein Engineering-Tool über den entsprechenden Tool-Konnektor ETC1, ETC2, ETC3 am richtigen Ort zu starten bzw. zu triggern.

Auf eine Datenanfrage z.B. des Engineering-Tools ET1 nach Engineering-Daten des Engineering-Tools ET3 bei z.B. dem Domain-Server DS1 fragt dessen Speicherverwaltung CM1 den Tool-Broker-Server TBSV an, um den zugehörigen Tool-Konnektor ETC3 zu identifizieren. Nach Identifizierung des zugehörigen Tool-Konnektors ETC3 kann das Engineering-Tool ET3 über die Domain-Interfaces DI1 mit dem Befehl "Trigger Tool Launch" gestartet werden. Der Start der Engineering-Tools wird immer in einem Domain-Kontext ausgeführt, z.B. ist eine Datenanfrage einer Domain der Initiator für Aktivitäten der Engineering-Tools im Hintergrund.

Erfindungsgemäß erfolgt eine Resynchronisation mit dem Systemspeicher SR. Zunächst registrieren sich die Engineering-Tools ET1... ETx für die gemeinsamen Daten, an denen diese interessiert sind. Diejenigen Engineering-Tools ET1... ETx bzw. Domain-Services DS1... DSn, die für einen Austausch von Daten noch nicht bereit sind, erlauben nur eine exklusive Modifikation, d. h. ein Benutzer zur gleichen Zeit. Dies resultiert daraus, dass die Engineering-Tools ET1...ETx sowie die Domain-Services DS1... DSn mit dem einen zentralen Datenspeicher SR gekoppelt sind.

Modifikationen von Daten in einem Projekt wie beispielsweise einer Roboterzelle können Einflüsse auf andere teilnehmende Projekte haben. Wenn z. B. ein Engineering-Tool nach Trennung von dem Engineering-Server wieder mit diesem verbunden wird, fragt dieses Engineering-Tool nach Änderungen von Daten, die in der Zwischenzeit erfolgt sind. Diese Änderungen werden in einer anhängigen Aktionsliste gesammelt. Viele der Änderungen in der anhängigen Aktionsliste können von dem wiederangeschlossenen Engineering-Tool selbst verarbeitet werden. Einige der Änderungen benötigen jedoch einen Benutzereingriff. Solange nicht alle die in der anhängigen Aktionsliste gelisteten Aktionen ausgeführt sind, verbleibt das System inkonsistent. Die Integrität bleibt jedoch erhalten. Das Zulassen einer vorübergehenden Inkonsistenz ist ein wesentlicher Aspekt des erfindungsgemäßen Verfahrens.

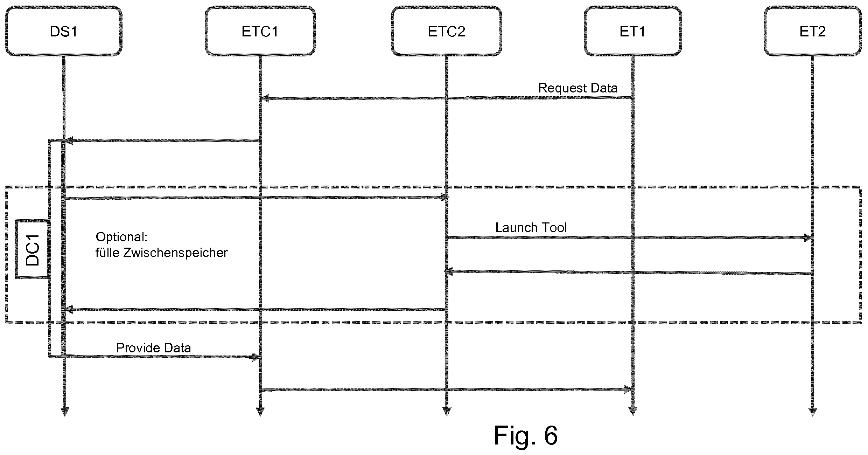

Fig. 6 zeigt ein weiteres Sequenzdiagramm zur Darstellung einer Kommunikation zwischen Engineering-Tools ET1, ET2 und z.B. dem Domain-Service DS1. Im dargestellten Beispiel sendet das Engineering-Tool ET1 die Anfrage "Request Data" über den Tool-Konnektor ETC1 an den Domain-Service DS1. Dem Domain-Service DS1 ist der Zwischenspeicher DS1 zugeordnet.

Über eine Nachricht "ProvideData" werden die Daten des Engineering-Tools ET2 über den Tool-Konnektor ET1 dem Engineering-Tool ET1 angeboten. Die Engineering-Tool-Konnektoren ETC1, ETC2 sind den Engineering-Tools ET1, ET2 jeweils zugeordnet und verarbeiten den Datenaustausch von und zu dem Zwischenspeicher DC 1. Die Anforderung von Daten erfolgt immer über dasselbe Domain-Interface, unabhängig von der Zwischenspeicher-Strategie. Wenn die Daten nicht verfügbar sind, werden die bereitstellenden Engineering-Tools angefragt, um den Zwischenspeicher DC1 zu bedienen.

Optional besteht die Möglichkeit, dass der Domain-Service DS1 während einer Zwischensequenz "OptionalFillCache" den Zwischenspeicher füllt. Dann sendet der Domain-Service DS1 ein Startsignal "LaunchTool" an das Engineering-Tool ET2, wodurch dieses gestartet wird. Sodann werden angeforderte Daten von dem Engineering-Tool ET2 über den Tool-Konnektor ETC2 in den Zwischenspeicher CB1 geladen.

Bevor die Kollaboration zwischen den Engineering-Tools ET1...ETx gestartet wird, müssen sowohl der Engineering-Server ESV als auch die Engineering-Tools ET1...ETx vorbereitet werden, um die zuvor erwähnte und erläuterte Zwischenspeicherungs-Strategie sowie Start-Strategie der Engineering-Tools anzuwenden.

Zunächst müssen die Datenselektionskriterien DSC definiert werden. Diese werden in dem gemeinsamenstandardisierten Speicher CR definiert und gespeichert.

Bei jeder Installation eines Engineering-Servers ESV auf einer Datenverarbeitungsanlage werden Hardware-Informationen und Engineering-Tool-Informationen registriert. Dabei werden statische Hardware-Informationen und statische Engineering-Tool-Informationen in dem gemeinsamen Datenspeicher CR gespeichert.

Sodann werden Datenselektionsattribute in dem Engineering-Tool konfiguriert. Anschließend sind die Engineering-Tools bereit um die Attribute der Daten zu generieren, die von einem Benutzer verarbeitet werden.

In einem weiteren Schritt wird die Start-Strategie für Engineering-Tools konfiguriert. Die Konfiguration umfasst die Formulierung von Regeln, welche die Zwischenspeicherung und die Start-Strategie der Engineering-Tools beeinflussen, und zwar auf der Grundlage von statischen Daten/Informationen STI der Workstations, statistischen Daten/Informationen STI der Engineering-Tools, dynamischen Daten/Informationen DYI der Workstations, dynamischen Daten/Informationen DYI der Engineering-Tools sowie Datenselektionskriterien.

Anschließend sind die Engineering-Tools sowie der gemeinsame Datenspeicher SR des Engineering-Servers ESV startbereit.

Das Engineering-Verfahren umfasst eine Initialisierungs-Phase, eine Strategie-Auswahl-Phase sowie eine Ausführungs-Phase in Form einer Ausführungsschleife.

Die Initialisierungs-Phase umfasst die Bestimmung von Installationsorten für Engineering-Tools, die Bestimmung von Hardwareinformationen der Workstations, die Bestimmung der Belastung der Workstations, die Bestimmung eines Start-Status der Engineering-Tools, die Bestimmung eines Betriebs-Status der Engineering-Tools, das Einlesen der Start-Strategie-Konfiguration der Engineering-Tools sowie die Bestimmung der Datenselektionskriterien.

Die Strategie-Auswahl-Phase umfasst die Bestimmung des Ortes der Engineering-Tools, die Bestimmung der Start-Strategie der Engineering-Tools sowie die Bestimmung der Zwischenspeicherungs-Strategie der einzelnen Datenklassen.

Die Ausführungs-Phase umfasst zunächst die Überprüfung der Größe des zur Verfügung stehenden Zwischenspeichers. Stimmt die Größe des Zwischenspeichers mit den zu speichernden Daten überein erfolgt ein vollständiges Update des Zwischenspeichers. Sodann wird die Start-Strategie der Engineering-Tools aktualisiert.

Wird bei der Überprüfung des Zwischenspeichers festgestellt, dass dieser limitiert ist erfolgt lediglich ein selektiver Update des Zwischenspeichers. Sodann wird die Start-Strategie der Engineering-Tools aktualisiert.

Sollte kein Zwischenspeicher zur Verfügung stehen, erfolgt kein Update des Zwischenspeichers, sondern unmittelbar eine Verwaltung der Start-Strategie der Engineering-Tools.

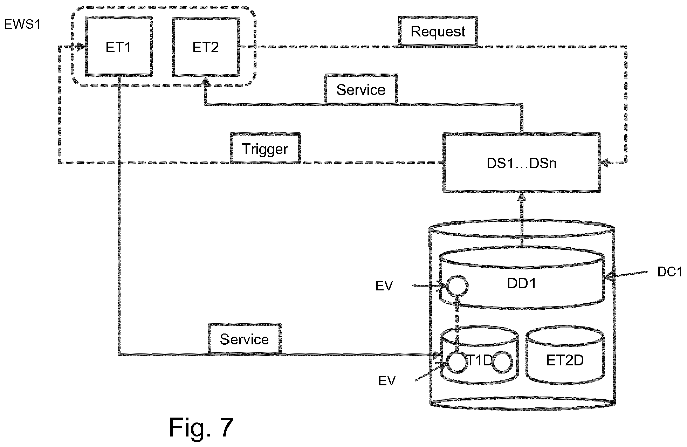

Die Fig. 7 - 10 zeigen rein schematisch Verfahren zum Datenaustausch zwischen Engineering-Tools ET1, ET2 in Abhängigkeit der Klasse der auszutauschenden Daten sowie in Abhängigkeit der Lokalisation der Engineering-Tools ET1, ET2.

Fig. 7 zeigt rein schematisch den Austausch von Engineering-Daten ED zwischen einem Engineering-Tool ET1 und einem Engineering-Tool ET2, die auf derselben Workstation EWS1 installiert sind. Das Engineering-Tool ET2 fragt über die Anfrage "Request" bei dem entsprechenden Domain-Service, im vorliegenden Fall DS1,"Class-2"-Engineering-Daten ED an, die von dem Engineering-Tool ET1 verarbeitet werden. Der Domain-Service DS1 triggert über die Nachricht "Trigger" das Engineering-Tool ET1 um den Zwischenspeicher DC1 zu aktualisieren, falls der Zwischenspeicher DC1 die angefragten Engineering-Daten EV nicht enthalten sollte.

Die in Fig. 7 dargestellte Strategie kann z. B. bei der Konfiguration eines Variablenaustauschs verwendet werden. Das Engineering-Tool ET1 stellt beispielsweise eine Variable EV bereit, die von dem Engineering-Tool ET2übernommen werden soll. Da in den Engineering-Daten ET1D des Engineering-Tools ET1 in dem der Domain DS1 zugeordneten Zwischenspeicher DC1 eine geeignete Variable EV nicht sichtbar ist, wird das Engineering-Tool ET1 durch den Domain-Service DS1 gestartet, um mehr Variablen EV zu erhalten, von denen eine Auswahl erfolgen oder eine neue Variable erzeugt werden kann. Die ausgewählte bzw. neu kreierte Variable EV wird sodann dem Zwischenspeicher DC1 hinzugefügt.

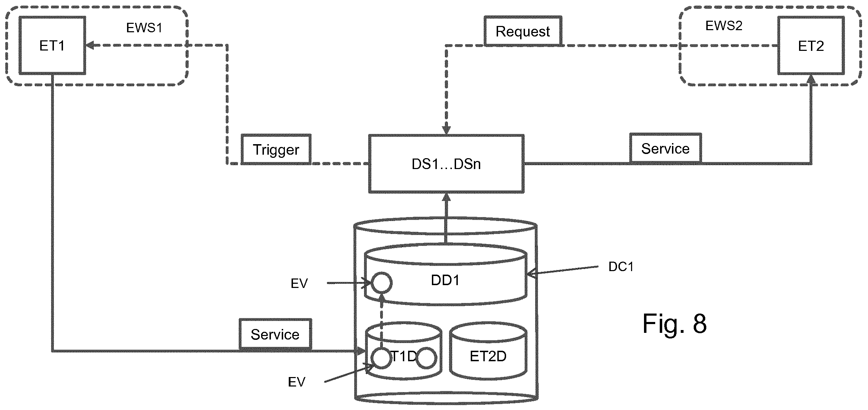

Fig. 8 zeigt ein Beispiel eines Datenaustauschs zwischen zwei Engineering-Tools ET1, ET2, die auf getrennten Workstations WS1, WS2 installiert sind. Das Engineering-Tool ET2 fragt über den Befehl "Request" nach "Class 2"-Engineering-Daten EV, die von dem Engineering-Tool verarbeitet werden. Der Domain-Service DS1 triggert mit der Nachricht "Trigger" das Engineering-Tool ET1 um Engineering-Daten EV in den Zwischenspeicher DC1 zu laden, d. h. diesen zu aktualisieren. Über den Domain-Service DS1 werden die Engineering-Tool-Daten EV dem Engineering-Tool ET2 zur Verfügung gestellt.

In diesem Zusammenhang ist anzumerken, dass der Service "Trigger" des Domain-Service DS1 nicht notwendigerweise einen zentralen Server mit einem entsprechenden Tool-Broker impliziert. Sollte ein Tool-Konnektor ETC1, ETC2 eines Engineering-Tools ET1, ET2 ausgebildet sein, um Instanzen von Engineering-Tools irgendwo in einem Netzwerk zu betreuen, dann kann der Tool-Konnektor ein Engineering-Tool irgendwo in dem Netzwerk starten.

Folglich hängt es grundsätzlich davon ab, wie die Tool-Konnektoren ausgebildet sind, um auf eine Instanz eines Engineering-Tools zuzugreifen. Jedoch ist ein gemeinsamer Tool-Broker-Service für die Engineering-Systemarchitektur eine Option und nicht zwingend erforderlich.

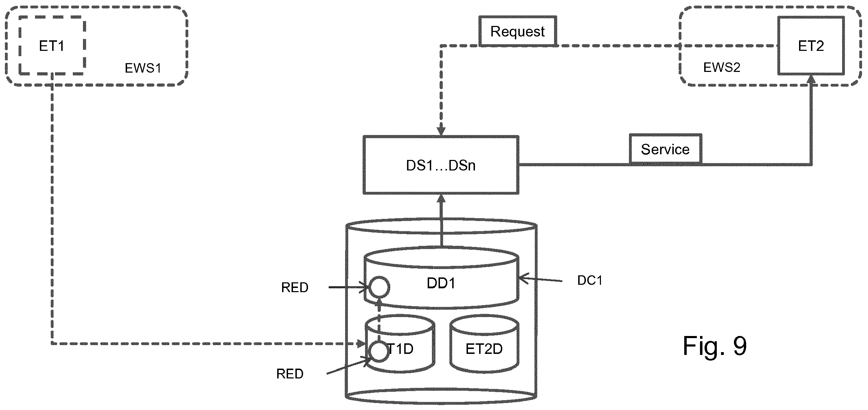

Fig. 9 zeigt rein schematisch den Austausch von Daten insbesondere "Class1"-Daten zwischen Engineering-Tools ET1, ET2 die in unterschiedlichen Workstations EWS1, EWS2, installiert sind. Im dargestellten Ausführungsbeispiel ist das Engineering-Tool ET1 nicht in Betrieb, hat jedoch zuvor eine Datenspeicherung von Engineering-Daten ET1d in den Zwischenspeicher CB1 angestoßen. Das Engineering-Tool ET2 fragt über den Befehl "Request" Engineering-Daten RED an, die von dem Engineering-Tool ET1 verarbeitet werden. Über den Domain-Service DS1 werden die Engineering-Daten RED des Engineering-Tools ET1 dem Engineering-Tool ET2 aus dem Zwischenspeicher DC1 zur Verfügung gestellt.

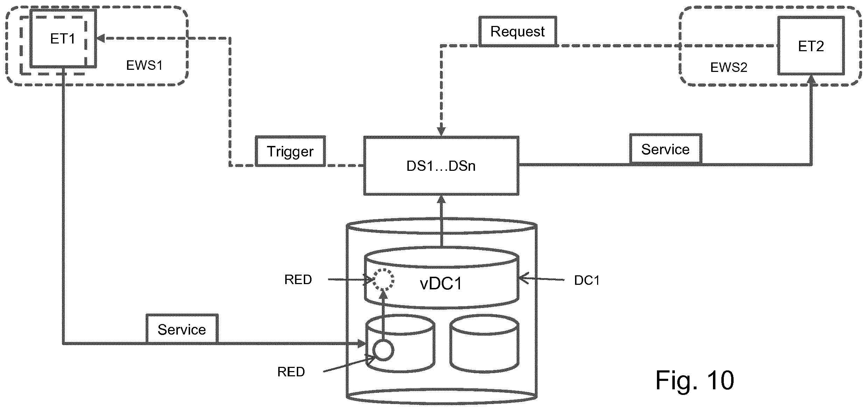

Fig. 10 zeigt rein schematisch den Austausch von Engineering-Daten RED zwischen dem Engineering-Tool ET1 und ET2, wobei die Engineering-Tools auf separaten Workstations EWS1, EWS2 installiert sind und das Engineering-Tool ET1nicht in Betrieb ist. Über den Befehl "Request" fragt das Engineering-Tool ET2 Engineering-Daten RED an, die von Engineering-Tool ET1 verarbeitet werden.

Über den Domain-Service DS1 wird das Engineering-Tool ET1 in der Workstation EWS1 getriggert und in Betrieb gesetzt. Das Engineering-Tool ET1 speichert die angeforderten Engineering-Daten RED in dem "virtuellen" Zwischenspeicher VDC1, aus dem die Engineering-Daten RED über den Domain-Service DS1 dem Engineering-Tool zur Verfügung gestellt werden.

## Patentansprüche

1. Verfahren zum Austausch von Engineering-Daten (RED) zwischen unabhängigen Engineering-Tools (ET1...ETx) eines Engineering-Systems (ESY),
wobei einem Projekt wie Fertigungsanlage, Schaltanlage oder Roboterzelle zugeordnete Engineering-Daten (ET1PD...ETxPD) jedes der Engineering-Tools (ET1...ETx) in einem dem Engineering-Tool zugeordneten Datenspeicher (SR, SPMR) in einem Tool-spezifischen Datenformat gespeichert werden und
wobei von einem Benutzer selektierte, einer Systemfunktion (SF1...SFn) wie Projekt-Management-Funktion, Topologie-Management-Funktion, Variablen-Austausch-Funktion oder Diagnose-Funktion zugeordnete Engineering-Daten (ET1D...ETxD) der Engineering-Tools, die für zumindest ein weiteres der Engineering-Tools von Interesse sind, mittels einer Konvertierungseinheit (ETC1...ETCx) in ein standardisiertes Datenformat konvertiert und in einem standardisierten gemeinsamen Datenspeicher (CC) gespeichert werden,
**dadurch gekennzeichnet,**
**dass** Änderungen der selektierten, einer Systemfunktion (SF1...SFn) zugeordneten Engineering-Daten (ET1D...ETxD) der einzelnen Engineering-Tools (ET1D...ETxD) in dem standardisierten gemeinsamen Datenspeicher (CC) kontinuierlich zwischengespeichert und bei Bedarf jeder Zeit von einem der Engineering-Tools (ET1...ETx) gelesen werden und dass für einen temporären Zugriff auf die gesamten, dem Projekt zugeordneten Engineering-Daten (ET1PD...ET1XPD) durch ein anfragendes Engineering-Tool ein Start des bereitstellenden Engineering-Tools ausgeführt wird.

2. Verfahren nach Anspruch 1,
**dadurch gekennzeichnet,**
**dass** die Zwischenspeicherung nach einer Zwischenspeicherungs-Strategie (CS) durchgeführt wird, wobei die Engineering-Daten entsprechend einer Datenklassifizierung zwischengespeichert werden, umfassend:
Cass-1-Daten, die zwischengespeichert und aktualisiert werden, so dass auf diese jederzeit zugegriffen werden kann, ohne dass das zugehörige Engineering-Tool in Betrieb ist,
Class-2-Daten, die teilweise zwischengespeichert werden, wobei das zugehörige Engineering-Tool vollen Zugriff auf die gesamten, einem Projekt zugeordneten Daten sicherstellt,
Class-3-Daten, die nicht zwischengespeichert werden, jedoch über das bereitstellende Engineering-Tool verfügbar sind und
Class-0-Daten, die nicht in das gemeinsame Datenmodell transformiert werden und ausschließlich über ein spezifisches Interface (SPMI) der Engineering-Tools (ET1...ETx) gelesen werden.

3. Verfahren nach Anspruch 1 oder 2,
**dadurch gekennzeichnet,**
**dass** Systemfunktionen (SF1...SFn) des Engineering-Systems (ESY) in Form von Variablen-Management, Diagnose-Management, Firmware-Management, Applikations-Management, Funktions-Management, Netzwerk-Management, Hardwarekonfigurations-Management u.a. als standardisierte gemeinsame Domain-Services (DS1...DSn) bereitgestellt werden und dass die Engineering- Tools über die Domain-Services auf die gemeinsamen standardisierten Engineering-Daten zugreifen.

4. Verfahren nach zumindest einem der vorhergehenden Ansprüche,
**dadurch gekennzeichnet,**
**dass** die Domain-Services (DS1...DSn) jeweils ein gemeinsames standardisiertes Datenmodell (CDM1...CDMn) zur Darstellung ihrer Domain-Daten (DD1...DDn) bereitstellen.

5. Verfahren nach zumindest einem der vorhergehenden Ansprüche,
**dadurch gekennzeichnet,**
**dass** die Zwischenspeicherung von selektierten Engineering-Daten (ED) und/oder der Start eines der Engineering-Tools unter Berücksichtigung von Datenselektionskriterien (DSC), Selektionsstatistiken (STA) statischen Informationen (STI) und/oder dynamischen Informationen (DYI) ausgeführt wird.

6. Verfahren nach zumindest einem der vorhergehenden Ansprüche,
**dadurch gekennzeichnet,**
**dass** die Datenselektionskriterien (DSC) durch einen Benutzer vorgegeben werden und dass die Selektionsstatistiken (STA) durch mitlesen der angeforderten Engineering-Daten erstellt werden.

7. Verfahren nach zumindest einem der vorhergehenden Ansprüche,
**dadurch gekennzeichnet,**
**dass** die Engineering-Tools (ET1...ETx) über die Domain-Services (DS1...DSn) untereinander sowie mit dem gemeinsamen standardisierten Datenspeicher (DD1...DDn) kommunizieren.

8. Verfahren nach zumindest einem der vorhergehenden Ansprüche,
**dadurch gekennzeichnet,**
**dass** die auf ein Projekt bezogenen Engineering-Daten und/oder die auf eine Systemfunktion bezogenen Daten eines Engineering-Tools nach dem Abtrennen in dem gemeinsamen Datenspeicher (CC; SR) gespeichert werden.

9. Verfahren nach zumindest einem der vorhergehenden Ansprüche,
**dadurch gekennzeichnet,**
**dass** die Konvertierung der Engineering-Daten in jedem einzelnen Engineering-Tool mittels des Tool-Konnektors (ETC1...WTCx) ausgeführt wird.

10. Engineering-System (ESY) zum Austausch von Engineering-Daten (RED) zwischen unabhängigen Engineering-Tools (ET1...ETx) des Engineering-Systems (ESY),
wobei einem Projekt wie Fertigungsanlage, Schaltanlage oder Roboterzelle zugeordnete Engineering-Daten (ET1PD...ETxPD) jedes der Engineering-Tools (ET1...ETx) in einem dem Engineering-Tool zugeordneten Datenspeicher (SR, SPMR) in einem Tool-spezifischen Datenformat gespeichert sind und
wobei von einem Benutzer selektierte, einer Systemfunktion (SF1...SFn) wie Projekt-Management-Funktion, Topologie-Management-Funktion, Variablen-Austausch-Funktion oder Diagnose-Funktion zugeordnete Engineering-Daten (ET1D...ETxD) der Engineering-Tools, die für zumindest ein weiteres der Engineering-Tools von Interesse sind, mittels einer Konvertierungseinheit (ETC1...ETCx) in ein standardisiertes Datenformat konvertiert und in einem standardisierten gemeinsamen Datenspeicher (CC) gespeichert werden, **dadurch gekennzeichnet,**
**dass** die Systemfunktionen (SF1...SFn) als Domain-Services (DS1...DSn) mit einem gemeinsamen standardisierten Datenmodell (CM1...CMn) ausgebildet sind, wobei Änderungen der selektierten, einer Systemfunktion (SF1...SFn) zugeordneten Engineering-Daten (ET1D...ETxD) der einzelnen Engineering-Tools (ET1D...ETxD) mittels der Domain-Services in dem standardisierten gemeinsamen Datenspeicher (CC) kontinuierlich zwischengespeichert und bei Bedarf jeder Zeit von einem der Engineering-Tools (ET1...ETx) lesbar sind und dass für einen temporären Zugriff auf die gesamten, dem Projekt zugeordneten Engineering-Daten (ET1PD...ET1XPD) durch ein anfragendes Engineering-Tool mittels eines Start-Mechanismus ein Start des bereitstellenden Engineering-Tools und/oder des die Daten bereitstellenden Daten-Servers ausgeführt wird.

11. Verfahren nach zumindest einem der vorhergehenden Ansprüche,
**dadurch gekennzeichnet,**
**dass** Instanzen der Engineering-Tools (ET1...ETx) auf dem Engineering-Server (ESV) installiert sind und dass die Instanz des Engineering-Tools auf dem Engineering-Server gestartet wird, um auf die gesamten Daten dieses Engineering-Tools zuzugreifen.
